# EUROPEAN PATENT APPLICATION

(11) **EP 4 779 250 A1**
(43) Date of publication of application: **22.07.2026**
(21) Application number: 25181998.3
(22) Date of filing: 11.06.2025
(51) Int. Cl.: F28D 15/02

(54) **HEAT DISSIPATION APPARATUS, HEAT SINK AND ELECTRICAL DEVICE**

(30) Priority: 17.01.2025 CN 202520127721 U
(71) Applicant: Sungrow Power Supply Co., Ltd., Hefei, Anhui 230088 (CN)
(72) Inventor: HAN, Qi, Hefei, 230088 (CN); SHU, Wentao, Hefei, 230088 (CN); ZHENG, Hao, Hefei, 230088 (CN); ZHANG, Guoqi, Hefei, 230088 (CN); YANG, Ye, Hefei, 230088 (CN); PAN, Nianan, Hefei, 230088 (CN); CHEN, Changchun, Hefei, 230088 (CN)
(74) Representative: Epping - Hermann - Fischer

(57) **Abstract**

The present application discloses a heat dissipation apparatus, a heat sink and an electrical device. The heat dissipation apparatus includes a heat sink and a first bursting component, the heat sink has a heat-exchange medium channel, the first bursting component is provided on the heat sink and is in communication with the heat-exchange medium channel. When a temperature of the heat-exchange medium rises to a set value (a pressure of the heat-exchange medium rises to a bursting pressure of the first bursting component), the first bursting component breaks out. A spot bursting can be realized by setting the location of the first bursting component, and an orientated bursting can be realized by setting the orientation of the first bursting component, so that foreign matters or shock waves generated by bursting can be far away from a specific device or a specific area, thereby reducing the damage to the specific device or a personnel at the specific area. Therefore, the heat dissipation apparatus can reduce the damage caused by bursting.

## Description

### FIELD

The present application relates to the technical field of heat dissipation of electrical devices, and in particular, to a heat dissipation apparatus, a heat sink, and an electrical device.

### BACKGROUND

An electrical device usually adopts a heat sink for heat dissipation, and the heat sink has a heat-exchange medium inside. In the event of an abnormality in the electrical device, the temperature and the pressure of the heat-exchange medium may rise rapidly, resulting in a risk of bursting of the heat sink, and foreign matters or shock waves generated by bursting may cause great damage to surrounding device or personnel.

In summary, how to reduce the damage caused by the bursting is an urgent problem to be solved by those skilled in the art.

### SUMMARY

The present application provides a heat dissipation apparatus, a heat sink, and an electrical device to reduce the damage caused by bursting.

The present application provides following technical solutions. A heat dissipation apparatus includes a heat sink and a first bursting component, and the heat sink has a heat-exchange medium channel, and the first bursting component is provided on the heat sink, and the first bursting component is in communication with the heat-exchange medium channel.

In an embodiment, a bursting pressure of the first part of the first bursting component is lower than a bursting pressure of a second part of the first bursting component.

In an embodiment, the first bursting component is a pipe, and the first part and the second part are distributed in an axial direction of the first bursting component.

In an embodiment, two second parts are provided and distributed in the axial direction of the first bursting component, and the first part is located between the two second parts.

In an embodiment, a cross section of the first part is the same as that of the second part in shape, and the cross section is perpendicular to the axial direction of the first bursting component. An inner wall of the first part has a width equal to that of an inner wall of the second part in a radial direction of the first bursting component, and an outer wall of the first part has a width smaller than that of an outer wall of the second part in the radial direction; or an inner wall of the first part has a width greater than that of an inner wall of the second part in the radial direction, and an outer wall of the first part has a width equal to that of an outer wall of the second part in the radial direction.

In an embodiment, a wall thickness of the first part of the first bursting component is smaller than a wall thickness of the second part of the first bursting component;
and/or, the first bursting component is a pipe, the first part and the second part are distributed in an axial direction of the first bursting component, the cross section of the first part is the same as that of the second part in shape, and the cross section is perpendicular to the axial direction of the first bursting component; an inner wall of the first part has a width greater than that of an inner wall of the second part in an radial direction of the first bursting component;
and/or, the first bursting component is a pipe, the first part and the second part are distributed in an axial direction of the first bursting component, the cross section of the first part is the same as that of the second part in shape, and the cross section is perpendicular to the axial direction of the first bursting component; an outer wall of the first part has a width smaller than that of an outer wall of the second part in an radial direction of the first bursting component;
and/or, a material strength of the first part is smaller than that of the second part;
and/or, the first part has a groove.

In an embodiment, a bursting pressure of the first bursting component is lower than that of the heat sink.

In an embodiment, one end of the first bursting component is fixed to the heat sink and communicated with the heat-exchange medium channel; and/or, the first bursting component is a pipe.

In an embodiment, the heat sink includes a condensation end, a heating end and a connection pipe assembly. The connection pipe assembly includes at least one of a first connection pipe and a second connection pipe, the first connection pipe is in communication with an outlet of the condensation end and an inlet of the heating end, and the second connection pipe is in communication with an inlet of the condensation end and an outlet of the heating end; and the first bursting component is provided on at least one of the condensation end, the heating end and the connection pipe assembly.

In an embodiment, the heat sink includes a condensation end and a heating end, the condensation end is connected to the heating end, and a heat-exchange medium channel of the condensation end is directly communicated with a heat-exchange medium channel of the heating end. The first bursting component is provided on at least one of the condensation end and the heating end.

In an embodiment, the first bursting component is provided at the condensation end, the first bursting component is provided on at least one of a collecting pipe and a condensation pipe of the condensation end.

In an embodiment, the heating end is an evaporation end.

In an embodiment, the heat sink is provided with an injection pipe for injecting a heat-exchange medium, and the first bursting component is provided on the injection pipe.

In an embodiment, the first bursting component is provided at one end of the injection pipe in an axial direction. Alternatively, the first bursting component is provided on a circumferential side wall of the injection pipe.

In an embodiment, the injection pipe is provided on at least one of the condensation end and the heating end of the heat sink. Alternatively, the injection pipe is provided on at least one of the condensation end, the heating end and the connection pipe assembly of the heat sink.

In an embodiment, components of the heat sink forming the heat-exchange medium channel are channel components, and a part of the channel components is defined as a second bursting component.

In an embodiment, a bursting pressure of the second bursting component is lower than a bursting pressure of the channel component where the second bursting component is located. Alternatively, a bursting pressure of a third part of the second bursting component is lower than a bursting pressure of a fourth part of the second bursting component.

In an embodiment, the heat sink is provided with an injection pipe for injecting a heat-exchange medium, and the injection pipe is the second bursting component; and/or at least one of the condensation end, the heating end and the connection pipe assembly of the heat sink is defined as the second bursting component.

A heat sink includes a condensation end and a heating end, and the heating end is in communication with the condensation end and forms a circulation loop with the condensation end. The condensation end includes at least one condensation pipe, and at least one of the condensation pipes is defined as a second bursting component; and/or the heat sink further includes an injection pipe for injecting a heat-exchange medium, and the injection pipe is defined as a second bursting component.

In an embodiment, a bursting pressure of the second bursting component is lower than a bursting pressure of the channel component where the second bursting component is located.

In an embodiment, a bursting pressure of a third part of the second bursting component is lower than a bursting pressure of a fourth part of the second bursting component.

In an embodiment, at least two condensation pipes are provided, at least one of the condensation pipes is defined as a first condensation pipe, and at least one of the condensation pipes is defined as a second condensation pipe; the second condensation pipe is defined as a second bursting component, and a bursting pressure of the second condensation pipe is lower than a bursting pressure of the first condensation pipe.

In an embodiment, the injection pipe is provided on at least one of the heating end and the condensation end. Alternatively, the heat sink further includes a connection pipe assembly, and the connection pipe assembly includes at least one of a first connection pipe and a second connection pipe; the first connection pipe is communicated with an outlet of the condensation end and an inlet of the heating end, the second connection pipe is communicated with an inlet of the condensation end and an outlet of the heating end, and the injection pipe is provided on at least one of the condensation end, the heating end and the connection pipe assembly.

In an embodiment, the heating end is an evaporation end.

The present application further provides an electrical device, and the electrical device includes the heat dissipation apparatus according to any one of the above embodiments, or the heat sink according to any one of the above embodiments.

In the heat dissipation apparatus according to the present application, the first bursting component is provided on the heat sink and is in communication with the heat-exchange medium channel of the heat sink. When the temperature of the heat-exchange medium rises to a set value (the pressure of the heat-exchange medium rises to the bursting pressure of the first bursting component), the first bursting component bursts out. A spot bursting can be realized by setting the location of the first bursting component, and an orientated bursting can be realized by setting the orientation of the first bursting component, so that foreign matters or shock waves generated by bursting can be far away from a specific device or a specific area, thereby reducing the damage to the specific device or a personnel at the specific area. Therefore, the heat dissipation apparatus can reduce the damage caused by bursting.

In the heat sink according to the present application, the at least one condensation pipe at the condensation end is the second bursting component, and/or the injection pipe is the second bursting component; and when the temperature of the heat-exchange medium rises to a set value (the pressure of the heat-exchange medium rises to the bursting pressure of the second bursting component), the second bursting component bursts out. A spot bursting can be realized by setting the location of the second bursting component, or an orientated bursting can be realized by setting the orientation of the second bursting component, so that foreign matters or shock waves generated by bursting can be far away from a specific device or a specific area, thereby reducing the damage to the specific device or a personnel at the specific area. Therefore, the heat sink can reduce damage caused by bursting.

### BRIEF DESCRIPTION OF THE DRAWINGS

In order to more clearly explain the technical solutions in the embodiments of the present application or in the conventional technology, the accompanying drawings used in the description of the embodiments of the present application or the conventional technology will be briefly introduced below. Apparently, the accompanying drawings in the following description show only the embodiments of the present application. Based on the provided accompanying drawings, other accompanying drawings can be obtained by those skilled in the art without creative labor.
FIG. 1 is a schematic structural view of a heat dissipation apparatus according to an embodiment of the present application;
FIG. 2 is another schematic structural view of a heat dissipation apparatus according to an embodiment of the present application;
FIG. 3 is yet another schematic structural view of a heat dissipation apparatus according to an embodiment of the present application;
FIG. 4 is a schematic structural view of the heat dissipation apparatus shown in FIG. 3 viewed from another direction;
FIG. 5 is another schematic structural view of a heat dissipation apparatus according to an embodiment of the present application;
FIG. 6 is a schematic structural view of a heat sink according to an embodiment of the present application;
FIG. 7 is a schematic structural view of a condensation end in a heat sink according to an embodiment of the present application;
FIG. 8 is a schematic structural view of a first condensation pipe and a second condensation pipe in a heat sink according to an embodiment of the present application.

Reference numerals in the accompanying drawings are as follows:

| | | | |
|---|---|---|---|
| 100. | heat dissipation apparatus; | 10. | heat sink; |
| 20. | first bursting component; | 30. | fixing seat; |
| 40. | mounting seat; | 11. | condensation end; |
| 111. | condensation pipe; | 111a. | first condensation pipe; |
| 111b. | second condensation pipe; | 1111. | flat-pipe hole; |
| 112. | collecting pipe; | 112a. | first collecting pipe; |
| 112b. | second collecting pipe; | 12. | heating end; |
| 13. | first connection pipe; | 14. | second connection pipe; |
| 15. | injection pipe; | 16. | second bursting component; |
| 161. | third part; | 162. | fourth part; |
| 101. | channel component; | 21. | first part; |
| 22. | second part. | | |

### DETAILED DESCRIPTION OF THE EMBODIMENTS

The technical solutions in the embodiments of the present application will be described clearly and completely below in conjunction with the accompanying drawings in the embodiments of the present application. It is apparent that the described embodiments are only some of the embodiments of the present application and not all of the embodiments. Based on the embodiments of the present application, all other embodiments obtained by those skilled in the art without creative efforts will fall within the protection scope of the present application.

The technical solutions in the embodiments of the present application will be described clearly and completely below in conjunction with the accompanying drawings in the embodiments of the present application. The terminology used in the following embodiments is only for the purpose of describing specific embodiments, and is not intended to limit the present application. As used in the specification and appended claims of the present application, the singular expressions "a", "an", "the", "such", "this" and "this one" are intended to also include expressions such as "one or more", unsmaller the context clearly indicates the contrary. It should also be understood that in the embodiment of the present application, the term "one or more" refers to one, two or more; the term "and/or" describes an association relationship between related objects and indicates there may be three kinds of relationships, for example, A and/or B may indicate three cases, such as A exists alone, A and B exist at the same time, and B exists alone. In each case, a quantity of A may be one or more, and a quantity of B may be one or more. The symbol "/" generally indicates an "or" relationship between a former object and a latter object.

References to "one embodiment" or "embodiments" and the like described in this specification indicate that a particular feature, structure, or characteristic described in connection with this embodiment is included in one or more embodiments of the present application. Thus, the phrases "in one embodiment", "in some embodiments", "in other embodiments" and "in another embodiments" appearing in different places in this specification do not necessarily all refer to the same embodiment, but mean "one or more but not all embodiments" unsmaller otherwise emphasized. The terms "including", "comprising", "having" and their variations all mean "including but not limited to" unsmaller otherwise specifically emphasized.

The term "multiple" in the embodiment of the present application refers to two or more. It should be noted that in the description of the embodiment of the present application, words such as "first" and "second" are only intended to distinguish objects in description, and should not be construed as indicating or implying relative importance, nor can they be understood as indicating or implying order.

The expression "perpendicular" in the present application refers to "substantially perpendicular" in the actual operation. The expression "substantially perpendicular" may be understood as perpendicular with certain errors.

A heat dissipation apparatus, a heat sink and an electrical device are provided in the embodiments of the present application to reduce the damage caused by the bursting of the heat sink.

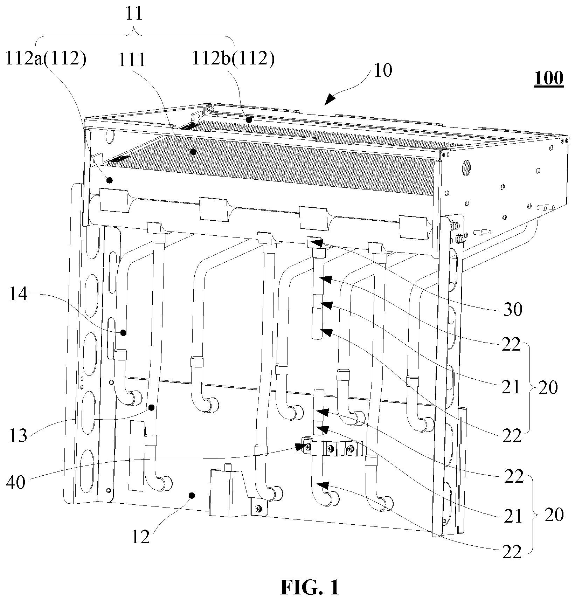

As shown in FIG. 1 to FIG. 5, a heat dissipation apparatus 100 is provided in an embodiment of the present application, including a heat sink 10 and a first bursting component 20.

The heat sink 10 has a heat-exchange medium channel (not shown in the figure), and a heat-exchange medium can flow through the heat-exchange medium channel. It can be understood that the heat-exchange medium is used to absorb heat generated by a heating apparatus (not shown in the figure). The heat-exchange medium may be solid, liquid or gas, or the heat-exchange medium can transform between liquid and gas, or the heat-exchange medium can transform between solid and liquid, or the heat-exchange medium can transform between solid and gas, or the heat-exchange medium can transform among solid, liquid and gas. When the heat-exchange medium may transform between liquid and gas, the heat sink 10 may be referred to as a syphon heat sink. When the heat-exchange medium is liquid, the heat sink 10 may be referred to as a water-cooled heat sink or another liquid-cooled heat sink.

The first bursting component 20 is provided on the heat sink 10, and the first bursting component 20 is in communication with the heat-exchange medium channel. It can be understood that the first bursting component 20 has a channel in communication with the heat-exchange medium channel. In this way, the first bursting component 20 can have a heat-exchange medium inside. When the temperature of the heat-exchange medium rises to a set value (the pressure of the heat-exchange medium rises to a bursting pressure of the first bursting component 20), the first bursting component 20 bursts out. A spot bursting can be realized by setting the location of the first bursting component 20, or an orientated bursting can be realized by setting the orientation of the first bursting component 20, so that foreign matters or shock wave generated by the bursting can be far away from a specific device or a specific area, thereby reducing the damage to the specific device or a personnel at the specific area. Therefore, the heat dissipation apparatus 100 can reduce the damage caused by the bursting.

Moreover, by setting the bursting pressure of the first bursting component 20, the first bursting component 20 can break out at a set pressure, which improves the safety and reliability of the heat dissipation apparatus 100.

It should be noted that the specific area may be referred to an area where a personnel often passes by or stays. The specific device may be referred to a component that is difficult to replace and maintain, or a component with a high cost, for example, the specific device is an electrical device such as a heating apparatus. Of course, the specific area may also be understood as other areas, and the specific device may also be understood as other devices, which is not limited in the embodiment of the present application.

In the heat dissipation apparatus 100, the first bursting component 20 may be welded to the heat sink 10, or the first bursting component 20 is fixed to the heat sink 10 by means of fasteners, etc.. The arrangement mode of the first bursting component 20 is not limited in the embodiments of the present application.

As shown in FIG. 1 to FIG. 5, one end of the first bursting component 20 is fixed to the heat sink 10 and is communicated with the heat-exchange medium channel. In this way, the installation of the first bursting component 20 can be simplified.

As shown in FIG. 1, in order to improve the stability of the first bursting component 20, the first bursting component 20 may be fixed to the heat sink 10 at a first position and communicated with the heat-exchange medium channel, and the first bursting component 20 is fixed to the heat sink 10 at a second position by means of a mounting seat 40, so that the stability of the connection between the first bursting component 20 and the heat sink 10 is improved.

The specific structure of the mounting seat 40 can be determined according to an actual situation, which is not limited in the embodiment of the present application.

In the heat dissipation apparatus 100, the structure, shape and dimension of the first bursting component 20 are designed according to actual situation, as long as the first bursting component 20 can be kept away from a specific device or a specific area.

In the heat dissipation apparatus 100, the first bursting component 20 may be a pipe. For example, the first bursting component 20 is a round pipe, a square pipe, a rectangular pipe, a spherical pipe, a hemispherical pipe, or a pipe of other shape, so that it is convenient for the first bursting component 20 to be communicated with the heat-exchange medium channel.

It can be understood that one end of the first bursting component 20 is closed and the other end of the first bursting component 20 is open, and the other end of the first bursting component 20 is communicated with the heat-exchange medium channel. It can be understood that the other end of the first bursting component 20 is connected to a component of the heat sink 10.

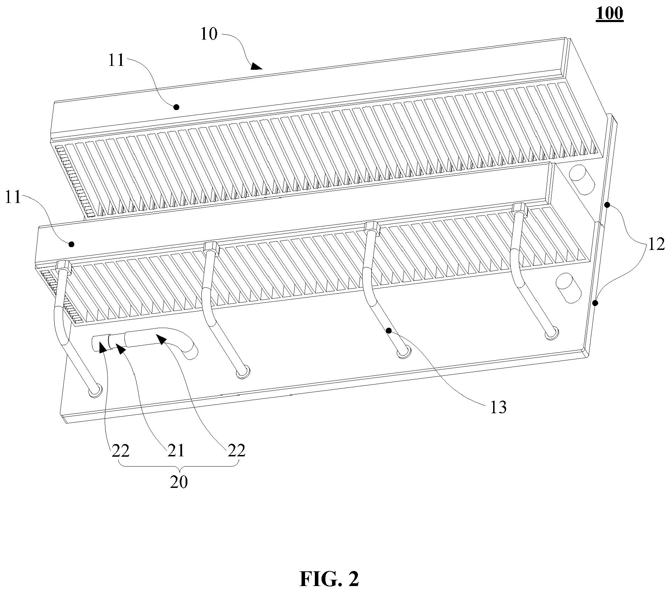

Illustratively, as shown in FIG. 1, FIG. 3 and FIG. 4, the first bursting component 20 is a straight pipe. As shown in FIG. 1 and FIG. 2, the first bursting component 20 is a bent pipe. The bent pipe may be an L-shaped pipe, an arc-shaped pipe, or the like, which is not limited in the embodiment of the present application.

In the embodiment of the present application, when the first bursting component 20 is a straight pipe, an axial end of the first bursting component 20 may be fixed to the heat sink 10 and be communicated with the heat-exchange medium channel.

The first bursting component 20 may be a single-layer pipe or a multi-layer pipe. The multi-layer pipe includes at least two pipes in an embedded way.

In practice, the first bursting component 20 may also be a box or other structures, and is not limited to a pipe, as long as the first bursting component 20 has a cavity for accommodating the heat-exchange medium, thereby ensuring the communication between the first bursting component 20 and the heat-exchange medium channel.

The first bursting component 20 can break out prior to the heat sink 10, or the first bursting component 20 is broken out and the heat sink 10 is not broken out. In order to achieve this, a bursting pressure of a first part 21 of the first bursting component 20 may be lower than that of a second part 22 of the first bursting component 20. In this way, the first part 21 is a weak part, and the first part 21 breaks out prior to the second part 22, or the first part 21 breaks out and the second part 22 is not blasted, so that the bursting at a specific position and in a specific direction can be further realized, and the damage caused by the bursting can be further reduced.

It should be noted that the first part 21 and the second part 22 of the first bursting component 20 are both used to be in contact with the heat-exchange medium, and the pressurization speed of the heat-exchange medium in the first part 21 is the same as that in the second part 22. The bursting pressure of the first part 21 refers to a maximum pressure borne by the first part 21 when the first part 21 breaks out, and the bursting pressure of the second part 22 refers to a maximum pressure borne by the second part 22 when the second part 22 breaks out. The dimensions of the first part 21 and the second part 22 can be determined according to actual situations, which will not be limited in the embodiment of the present application.

In the first bursting component 20, the fact that the first part 21 and the second part 22 are distinguished based on the bursting pressure does not indicate that the first bursting component 20 is designed as two components: the first part 21 and the second part 22. It can be understood that the first part 21 and the second part 22 are two separate components; or the first part 21 is integrated with the second part 22; or a portion of the first part 21 is integrated with a portion of the second part 22, and another portion of the first part 21 and another portion of the second part 22 are two separate components.

The first bursting component 20 is a pipe, a flow direction of the heat-exchange medium in the first bursting component 20 is an axial direction of the first bursting component 20, and a radial direction of the first bursting component 20 is perpendicular to the axial direction of the first bursting component 20.

In order to facilitate production and manufacture, the first part 21 and the second part 22 may be distributed along the axial direction of the first bursting component 20. The first part 21 and the second part 22 may be respectively located at two ends of the first bursting component 20 in the axial direction. Alternatively, there are two second parts 22 distributed along the axial direction of the first bursting component 20, and the first part 21 is located between the two second parts 22.

When the first bursting component 20 is processed by turning or other processes, there are two second parts 22 distributed along the axial direction of the first bursting component 20, and the first part 21 is located between the two second parts 22. In this way, the two second parts 22 may be fixed, which facilitates the processing of the first part 21.

In order to further facilitate the processing, the cross section of the first part 21 and the cross section of the second part 22 have the same shape, and the cross section of the first part 21 and the cross section of the second part 22 are both perpendicular to the axial direction of the first bursting component 20. Of course, the cross-section of the first part 21 and the cross-section of the second part 22 may be different in shape.

In the first bursting component 20, the first part 21 and the second part 22 may also be distributed along a circumferential direction of the first bursting component 20.

In the case that the bursting pressure of the first part 21 is lower than that of the second part 22, the first bursting component 20 may be a single-layer pipe, which simplifies the production and manufacture of the first bursting component 20. Of course, the first bursting component 20 may also be a multi-layer pipe, which can be understood as including at least two pipes in an embedded way, and two adjacent pipes are connected to each other in the radial direction.

In the case that the first part 21 and the second part 22 are distributed along the axial direction of the first bursting component 20 and the first bursting component 20 is a multi-layer pipe, the first part 21 is a single-layer pipe, and the second part 22 is a multi-layer pipe. Alternatively, both the first part 21 and the second part 22 are multi-layer pipes, and the number of layers of the first part 21 is smaller than that of the second part 22. In this way, it is convenient to process the first part 21 and the second part 22, and it is also convenient to achieve the bursting pressure of the first part 21 being lower than that of the second part 22.

Illustratively, the first bursting component 20 includes an inner pipe and outer pipes, wherein the outer pipes are mounted outside the inner pipe and located at two ends of the inner pipe, so that a portion between the two ends of the inner pipe is not nested by the outer pipe, the portion of the inner pipe that is not nested by the outer pipe forms a first part 21, and a portion of the inner pipe nested by the outer pipe and the outer pipe forms a second part 22.

In order to realize that the bursting pressure of the first part 21 of the first bursting component 20 is lower than that of the second part 22 of the first bursting component 20, in a first aspect, a wall thickness of the first part 21 may be smaller than that of the second part 22. In a second aspect, a material strength of the first part 21 may be smaller than that of the second part 22. In a third aspect, the first part 21 may have a groove. In the fourth aspect, the first bursting component 20 is a pipe, and the first part 21 and the second part 22 are distributed along the axial direction of the first bursting component 20; the cross section of the first part 21 is the same as that of the second part 22, and the width of an inner wall of the first part 21 in the radial direction of the first bursting component 20 is greater than that of an inner wall of the second part 22 in the radial direction of the first bursting component 20, and/or the width of an outer wall of the first part 21 in the radial direction of the first bursting component 20 is smaller than that of an outer wall of the second part 22 in the radial direction of the first bursting component 20.

Based on the first aspect, the second aspect, the third aspect, and the fourth aspect, there are mainly following fifteen options in the embodiments of the present application.

In a first option, the bursting pressure of the first part 21 of the first bursting component 20 can set to be lower than that of the second part 22 according to the first aspect. In this case, a relationship between the material strength of the first part 21 and the material strength of the second part 22, whether the first part 21 has a groove or not, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction can be determined according to actual situations, and are not limited to the second aspect, the third aspect and the fourth aspect above.

In a second option, the bursting pressure of the first part 21 of the first bursting component 20 can set to be lower than that of the second part 22 according to the first aspect and the second aspect. In this case, whether the first part 21 has a groove or not, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction are selected according to the actual situations, and are not limited to the third aspect and the fourth aspect above.

In a third option, the bursting pressure of the first part 21 of the first bursting component 20 can be set to be lower than that of the second part 22 according to the first aspect and the third aspect. In this case, a relationship between the material strength of the first part 21 and the material strength of the second part 22, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction can be determined according to actual situations, and are not limited to the second aspect and the fourth aspect above.

In a fourth option, the bursting pressure of the first part 21 of the first bursting component 20 can be set to be lower than that of the second part 22 according to the first aspect and the fourth aspect. In this case, a relationship between the material strength of the first part 21 and the material strength of the second part 22, and whether the first part 21 has a groove or not can be determined according to actual situations, and are not limited to the second aspect and the third aspect above.

In a fifth option, the bursting pressure of the first part 21 of the first bursting component 20 can be set to be lower than that of the second part 22 according to the first aspect, the second aspect and the third aspect. In this case, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction can be determined according to actual situations, and are not limited to the fourth aspect above.

In a sixth option, the bursting pressure of the first part 21 of the first bursting component 20 can be set to be lower than that of the second part 22 according to the first aspect, the second aspect and the fourth aspect. In this case, whether the first part 21 has a groove or not can be determined according to actual situations, and is not limited to the third aspect above.

In a seventh option, the bursting pressure of the first part 21 of the first bursting component 20 can be set to be lower than that of the second part 22 according to the first aspect, the third aspect and the fourth aspect. In this case, a relationship between the material strength of the first part 21 and the material strength of the second part 22 can be determined according to the actual situations, and is not limited to the second aspect above.

In an eighth option, the bursting pressure of the first part 21 of the first bursting component 20 can be set to be lower than that of the second part 22 according to the first aspect, the second aspect, the third aspect and the fourth aspect.

In a ninth option, the bursting pressure of the first part 21 of the first bursting component 20 can be set to be lower than that of the second part 22 according to the second aspect. In this case, a relationship between the wall thickness of the first part 21 and the wall thickness of the second part 22, whether the first part 21 has a groove or not, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction can be determined according to actual situations, and are not limited to the first aspect, the third aspect and the fourth aspect above.

In a tenth option, the bursting pressure of the first part 21 of the first bursting component 20 can be set to be lower than that of the second part 22 according to the second aspect and the third aspect. In this case, a relationship between the wall thickness of the first part 21 and the wall thickness of the second part 22, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction can be determined according to actual situations, and are not limited to the first aspect and the fourth aspect above.

In a eleventh option, the bursting pressure of the first part 21 of the first bursting component 20 can be set to be lower than that of the second part 22 according to the second aspect and the fourth aspect. In this case, a relationship between the wall thickness of the first part 21 and the wall thickness of the second part 22, and whether the first part 21 has a groove or not can be determined according to actual situations, and are not limited to the first aspect and the third aspect above.

In a twelfth option, the bursting pressure of the first part 21 of the first bursting component 20 can be set to be lower than that of the second part 22 according to the second aspect, the third aspect and the fourth aspect. In this case, a relationship between the wall thickness of the first part 21 and the wall thickness of the second part 22 can be determined according to actual situations, and is not limited to the first aspect above.

In a thirteenth option, the bursting pressure of the first part 21 of the first bursting component 20 can be set to be lower than that of the second part 22 according to the third aspect. In this case, a relationship between the wall thickness of the first part 21 and the wall thickness of the second part 22, a relationship between the material strength of the first part 21 and the material strength of the second part 22, the distribution direction of the first part 21 and the second part 22, whether the cross-sectional shape of the first part 21 and the cross-sectional shape of the second part 22 are the same or not, a relationship between the width of the inner wall of the first part 21 and the width of the inner wall of the second part 22 in the radial direction, and a relationship between the width of the outer wall of the first part 21 and the width of the outer wall of the second part 22 in the radial direction can be determined according to actual situations, and are not limited to the first aspect, the second aspect and the fourth aspect above.

In a fourteenth option, the bursting pressure of the first part 21 of the first bursting component 20 can be set to be lower than that of the second part 22 according to the third aspect and the fourth aspect. In this case, a relationship between the wall thickness of the first part 21 and the wall thickness of the second part 22, and a relationship between the material strength of the first part 21 and the material strength of the second part 22 can be determined according to actual situations, and are not limited to the first aspect and the second aspect above.

In a fifteenth option, the bursting pressure of the first part 21 of the first bursting component 20 can be set to be lower than that of the second part 22 according to the fourth aspect. In this case, a relationship between the wall thickness of the first part 21 and the wall thickness of the second part 22, a relationship between the material strength of the first part 21 and the material strength of the second part 22, and whether the first part 21 has a groove or not can be determined according to actual situations, and are not limited to the first aspect, the second aspect and the third aspect above.

It should be noted that the expression "a relationship between the wall thickness of the first part 21 and the wall thickness of the second part 22" mentioned above includes that: the wall thickness of the first part 21 is equal to that of the second part 22; or the wall thickness of the first part 21 is smaller than that of the second part 22; or the wall thickness of the first part 21 is greater than that of the second part 22.

It should be noted that the expression "a relationship between the material strength of the first part 21 and the material strength of the second part 22" mentioned above includes that: the material strength of the first part 21 is equal to that of the second part 22; or the material strength of the first part 21 is lower than that of the second part 22; or the material strength of the first part 21 is higher than that of the second part 22.

It should be noted that the expression "whether the first part 21 has a groove or not" mentioned above includes that: the first part 21 has a groove, or the first part 21 has no groove.

It should be noted that the expression "the distribution direction of the first part 21 and the second part 22" mentioned above includes that: an axial distribution of the first part 21 and the second part 22 along the first bursting component 20; or a circumferential distribution of the first part 21 and the second part 22 along the first bursting component 20; or other distribution directions of the first part 21 and the second part 22.

It should be noted that the expression "the cross-sectional shape of the first part 21 and the cross-sectional shape of the second part 22 are the same or not" mentioned above includes that: the first part 21 has a cross-sectional shape the same as that of the second part 22, or the first part 21 has a cross-sectional shape different from that of the second part 22.

It should be noted that the expression " a relationship between the width of the inner wall of the first part 21 and the width of the inner wall of the second part 22 in the radial direction" mentioned above includes that: the inner wall of the first part 21 has a width equal to that of the inner wall of the second part 22 in the radial direction; or the inner wall of the first part 21 has a width greater than that of the inner wall of the second part 22 in the radial direction; or the inner wall of the first part 21 has a width smaller than that of the inner wall of the second part 22 in the radial direction.

It should be noted that the expression "a relationship between the width of the outer wall of the first part 21 and the width of the outer wall of the second part 22 in the radial direction" mentioned above includes that: the outer wall of the first part 21 has a width equal to that of the outer wall of the second part 22 in the radial direction; or the outer wall of the first part 21 has a width greater than that of the outer wall of the second part 22 in the radial direction; or the outer wall of the first part 21 has a width smaller than that of the outer wall of the second part 22 in the radial direction.

In a fourth aspect, in a case that the width of the inner wall of the first part 21 in the radial direction of the first bursting component 20 is greater than that of the inner wall of the second part 22 in the radial direction of the first bursting component 20, there are the following three options.

In a first option, the width of the outer wall of the first part 21 is equal to that of the outer wall of the second part 22 in the radial direction of the first bursting component 20, so that the wall thickness of the first part 21 is smaller than that of the second part 22, and the bursting pressure of the first part 21 is lower than that of the second part 22. Moreover, it is convenient to process the outer wall of the first bursting component 20.

In a second option, the width of the outer wall of the first part 21 in the radial direction of the first bursting component 20 is smaller than that of the outer wall of the second part 22 in the radial direction of the first bursting component 20, so that the wall thickness of the first part 21 is smaller than that of the second part 22, and the bursting pressure of the first part 21 is lower than that of the second part 22.

In a third option, the width of the outer wall of the first part 21 in the radial direction of the first bursting component 20 is greater than that of the outer wall of the second part 22 in the radial direction of the first bursting component 20. By adjusting the width difference between the inner wall of the first part 21 and the inner wall of the second part 22 in the radial direction and the width difference of the outer wall of the first part 21 and the outer wall of the second part 22 in the radial direction, the wall thickness of the first part 21 can be set to be smaller than that of the second part 22, so that the bursting pressure of the first part 21 is lower than that of the second part 22.

In the fourth aspect, in a case that the width of the outer wall of the first part 21 in the radial direction of the first bursting component 20 is smaller than that of the outer wall of the second part 22 in the radial direction of the first bursting component 20, there are following three options.

In a first option, the width of the inner wall of the first part 21 is equal to that of the inner wall of the second part 22 in the radial direction of the first bursting component 20, so that the wall thickness of the first part 21 is smaller than that of the second part 22, and the bursting pressure of the first part 21 is lower than that of the second part 22. Moreover, it is convenient to process the inner wall of the first bursting component 20.

In a second option, the width of the inner wall of the first part 21 in the radial direction of the first bursting component 20 is smaller than that of the inner wall of the second part 22 in the radial direction of the first bursting component 20. By adjusting the width difference between the inner wall of the first part 21 and the inner wall of the second part 22 in the radial direction and the width difference of the outer wall of the first part 21 and the outer wall of the second part 22 in the radial direction, the wall thickness of the first part 21 can be smaller than that of the second part 22, so that the bursting pressure of the first part 21 is lower than that of the second part 22.

In a third option, the width of the inner wall of the first part 21 in the radial direction of the first bursting component 20 is greater than that of the inner wall of the second part 22 in the radial direction of the first bursting component 20. This case has been described above, and will not be described herein again.

In the fourth aspect, when the first bursting component 20 is a round pipe, both the first part 21 and the second part 22 are round pipe segments, the width of the inner wall of the first part 21 in the radial direction of the first bursting component 20 is an inner diameter of the first part 21, and the width of the outer wall of the first part 21 in the radial direction of the first bursting component 20 is an outer diameter of the first part 21. The width of the inner wall of the second part 22 in the radial direction of the first bursting component 20 is an inner diameter of the second part 22, and the width of the outer wall of the second part 22 in the radial direction of the first bursting component 20 is an outer diameter of the second part 22.

In the fourth aspect, when the first bursting component 20 is a square pipe, both the first part 21 and the second part 22 are square pipe segments, the width of the inner wall of the first part 21 in the radial direction of the first bursting component 20 is an inner side length of the first part 21, and the width of the outer wall of the first part 21 in the radial direction of the first bursting component 20 is an outer side length of the first part 21. The width of the inner wall of second part 22 in the radial direction of the first bursting component 20 is an inner side length of the second part 22, and the width of the outer wall of the second part 22 in the radial direction of the first bursting component 20 is an outer side length of the second part 22.

In an actual situation, other parameters of the first part of the first bursting component 20 may also be different from that of the second part of the first bursting component 20, and are not limited to the above four aspects.

In order to realize that the first bursting component 20 breaks out prior to the heat sink 10, or the first bursting component 20 breaks out and the heat sink 10 does not break out, the bursting pressure of the first bursting component 20 can be set to be lower than the bursting pressure of the heat sink 10. In this way, it is convenient to design the first bursting component 20, and also to produce and manufacture the first bursting component 20.

It should be noted that the bursting pressure of the first bursting component 20 refers to a maximum pressure borne by the first bursting component 20 when it breaks out; and the bursting pressure of the heat sink 10 refers to a maximum pressure borne by the heat sink 10 when it breaks out.

When the bursting pressure of the first bursting component 20 is lower than the bursting pressure of the heat sink 10, the first bursting component 20 may be divided into a first part 21 and a second part 22, or may not be divided into the first part 21 and the second part 22.

When the bursting pressure of the first bursting component 20 is lower than the bursting pressure of the heat sink 10, the structure, shape and material of the first bursting component 20 are not limited. For example, there are three aspects below.

In a first aspect, the first bursting component 20 may have an equal-wall-thickness structure.

In a second aspect, the first bursting component 20 may have the same material throughout.

In a third aspect, the first bursting component 20 has no groove.

The above three aspects may be implemented separately or in any combination, which is not limited in the embodiment of the present application.

The specific position of the first bursting component 20 is described below in conjunction with the specific structure of the heat sink 10.

As shown in FIG. 1, FIG. 2, and FIG. 4 to FIG. 7, the heat sink 10 includes a condensation end 11 and a heating end 12, which is in communication with the condensation end 11 and forms a circulation loop with the condensation end 11. The circulation loop is a structure of the heat-exchange medium channel mentioned above.

The heating end 12 may or may not have an evaporation function. In order to effectively improve the heat dissipation efficiency and the heat dissipation effect, the heating end 12 may have an evaporation function, and it can be understood that the heating end 12 is an evaporation end. In this case, the heat sink 10 is a syphon heat sink, the condensation end 11 may be referred to as a condenser, and the evaporation end may be referred to as an evaporator.

The heating end 12 may not have an evaporation function, and in this case, the heat sink 10 may be a liquid-cooled heat sink, such as a water-cooled heat sink. Alternatively, the heat sink 10 may be an air-cooled heat sink.

The first bursting component 20 is provided on at least one of the condensation end 11 and the heating end 12. Illustratively, the first bursting component 20 is provided at the condensation end 11, or the first bursting component 20 is provided at the heating end 12, or the condensation end 11 is provided with at least one first bursting component 20 and the heating end 12 is provided with at least one first bursting component 20. Illustratively, as shown in FIG. 1, the condensation end 11 is provided with one first bursting component 20, and the heating end 12 is provided with one first bursting component 20.

As shown in FIG. 1, FIG. 2, and FIG. 4 to FIG. 7, the condensation end 11 includes a condensation pipe 111. At least one condensation pipe 111 may be provided. In order to facilitate communication with the heating end 12, the condensation end 11 further includes a collecting pipe 112, which is in communication with the condensation pipe 111, so that the collecting pipe 112 realizes the convergence of the condensation pipe 111, thereby facilitating communication between the condensation pipe 111 and the heating end 12. Illustratively, the collecting pipe 112 is communicated with an inlet or an outlet of the condensation pipe 111. Alternatively, there are two collecting pipes 112, namely a first collecting pipe 112a and the second collecting pipe 112b. The first collecting pipe 112a is communicated with an outlet of the condensation pipe 111, the second collecting pipe 112b is communicated with an inlet of the condensation pipe 111, the first collecting pipe 112a is communicated with an inlet of the heating end 12, and the second collecting pipe 112b is communicated with an outlet of the heating end 12.

It should be noted that, in order to facilitate the liquid heat-exchange medium in the condensation end 11 flowing back to the heating end 12, the outlet of the condensation end 11 is lower than the inlet of the condensation end 11, and the first flow collection pipe 112a is lower than the second flow collection pipe 112b.

Based on the structure of the condensation end 11, the position of the first bursting component 20 has following three cases.

In a first case, the condensation end 11 includes at least one condensation pipe 111, and the first bursting component 20 is provided on the at least one condensation pipe 111. In this case, the bursting pressure of the first part of the first bursting component 20 is lower than the bursting pressure of the second part of the first bursting component 20. Alternatively, the bursting pressure of the first bursting component 20 is lower than that of the condensation pipe 111.

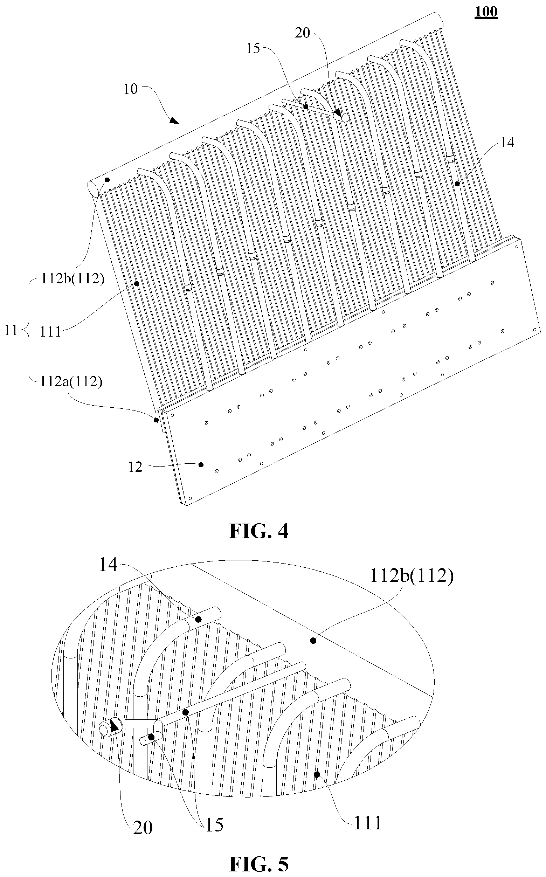

In a second case, the condensation end 11 includes a condensation pipe 111 and a collecting pipe 112, and the first bursting component 20 is provided on the condensation pipe 111, or the first bursting component 20 is provided on the collecting pipe 112, or at least one first bursting component 20 is provided on the condensation pipe 111 and at least one first bursting component 20 is provided on the collecting pipe 112. The collecting pipe 112 is a first collecting pipe 112a or a second collecting pipe 112b. Illustratively, as shown in FIG. 4, one first bursting component 20 is provided on the first collecting pipe 112a. In order to facilitate the arrangement of the first bursting component 20, the first bursting component 20 may be fixed to the first collecting pipe 112a by means of a fixing seat 30. This arrangement is also suitable for the case where the first bursting component 20 is provided on other pipes. A specific structure of the fixing seat 30 can be determined according to actual situations, which is not limited in the embodiment of the present application.

In the second case, the bursting pressure of the first part of the first bursting component 20 is lower than that of the second part of the first bursting component 20. Alternatively, the bursting pressure of the first bursting component 20 is lower than a bursting pressure of the pipe (the condensation pipe 111 or the collecting pipe 112) where the first bursting component 20 is located.

In a third case, the condensation end 11 includes a condensation pipe 111, a first collecting pipe 112a and a second collecting pipe 112b. The first bursting component 20 is provided on the condensation pipe 111, or the first bursting component 20 is provided on the first collecting pipe 112a; or the first bursting component 20 is provided on the second collecting pipe 112b; or the condensation pipe 111 is provided with at least one first bursting component 20 and the first collecting pipe 112a is provided with at least one first bursting component 20; or the condensation pipe 111 is provided with at least one first bursting component 20 and the second collecting pipe 112b is provided with at least one first bursting component 20; or the first collecting pipe 112a is provided with at least one first bursting component 20 and the second collecting pipe 112b is provided with at least one first bursting component 20; or the condensation pipe 111 is provided with at least one first bursting component 20 and the first collecting pipe 112a is provided with at least one first bursting component 20 and the second collecting pipe 112b is provided with at least one first bursting component 20. In this case, the bursting pressure of the first part of the first bursting component 20 is lower than that of the second part of the first bursting component 20. Alternatively, the bursting pressure of the first bursting component 20 is lower than a bursting pressure of the pipe (the condensation pipe 111, the first collecting pipe 112a or the second collecting pipe 112b) where the first bursting component 20 is located.

In the heat sink 10, the heating end 12 may be implemented as a heating plate or other structure.

In the heat sink 10, a heating device (not shown in the figure) can be mounted on a side of the heating end 12. When the first bursting component 20 is provided at the heating end 12, the first bursting component 20 is provided on one side of the heating end 12 far away from the heating device. Illustratively, as shown in FIG. 4, a heating device can be mounted on a right side of the heating end 12, and the first bursting component 20 is provided on a left side of the heating end 12. In this way, the damage to the heating device caused by bursting can be reduced. Of course, the first bursting component 20 may also be provided at other positions on the heating end 12, for example, the first bursting component 20 and the heating device are provided on the same side of the heating end 12, which is not limited in the embodiment of the present application.

In the heat sink 10, there are multiple manners for forming a circulation loop between the heating end 12 and the condensation end 11. As shown in FIG. 1, FIG. 2 and FIG. 4, the heat sink 10 further includes a first connection pipe 13 and a second connection pipe 14. The first connection pipe 13 is communicated with the outlet of the condensation end 11 and the inlet of the heating end 12, and the second connection pipe 14 is communicated with the inlet of the condensation end 11 and the outlet of the heating end 12.

It should be noted that when the condensation end 11 includes a first collecting pipe 112a and a second collecting pipe 112b, the first connection pipe 13 is communicated with the first collecting pipe 112a, and the second connection pipe 14 is communicated with the second collecting pipe 112b. The first connection pipe 13 is a component of a connection pipe assembly, and the second connection pipe 14 is a component of the connection pipe assembly.

When the structure of the heat sink 10 described above is adopted, the first bursting component 20 is provided at the condensation end 11; or the first bursting component 20 is provided at the heating end 12; or the first bursting component 20 is provided on the first connection pipe 13; or the first bursting component 20 is provided on the second connection pipe 14; alternatively, each of at least two of the condensation end 11, the heating end 12, the first connection pipe 13 and the second connection pipe 14 is are provided with the first bursting component 20. In this case, the bursting pressure of the first part of the first bursting component 20 is lower than the bursting pressure of the second part of the first bursting component 20. Alternatively, the bursting pressure of the first bursting component 20 is lower than a bursting pressure of the component (the condensation end 11, the heating end 12, the first connection pipe 13 or the second connection pipe 14) where the first bursting component 20 is located.

As shown in FIG. 5, the condensation end 11 may be connected to the heating end 12, and the heat-exchange medium channel of the condensation end 11 is directly communicated with the heat-exchange medium channel of the heating end 12. In this way, it is unnecessary to provide the first connection pipe 13 and the second connection pipe 14. In this case, the first bursting component 20 is provided at the condensation end 11; or the first bursting component 20 is provided at the heating end 12; alternatively, the condensation end 11 is provided with at least one first bursting component 20 and the heating end 12 is provided with at least one first bursting component 20. The bursting pressure of the first part of the first bursting component 20 is lower than the bursting pressure of the second part of the first bursting component 20. Alternatively, the bursting pressure of the first bursting component 20 is lower than a bursting pressure of the component (the condensation end 11 or the heating end 12) where the first bursting component 20 is located.

As shown in FIG. 5, the condensation end 11 may be connected to the heating end 12, and a gas channel of the condensation end 11 is directly communicated with the heat-exchange medium channel of the heating end 12, and a liquid channel of the condensation end 11 is communicated with the heat-exchange medium channel of the heating end 12 via the first connection pipe 13. In this way, it is unnecessary to provide the second connection pipe 14, and the connection pipe assembly includes the first connection pipe 13. In this case, the first bursting component 20 is provided at the condensation end 11. Alternatively, as shown in FIG. 5, the first bursting component 20 is provided at the heating end 12; or, the first bursting component 20 is provided on the first connection pipe 13; alternatively, each of at least two of the condensation end 11, the heating end 12 and the first connection pipe 13 are provided with the first bursting components 20. The bursting pressure of the first part of the first bursting component 20 is lower than the bursting pressure of the second part of the first bursting component 20. Alternatively, the bursting pressure of the first bursting component 20 is lower than the bursting pressure of the component (the condensation end 11, the heating end 12 or the first connection pipe 13) where the first bursting component 20 is located.

It should be noted that both the gas channel and the liquid channel of the condensation end 11 are portions of the heat-exchange medium channel of the condensation end 11. Both the gas and the liquid in the condensation end 11 are heat exchange media.

In an actual situation, the condensation end 11 may also be connected to the heating end 12, and the gas channel of the condensation end 11 is directly communicated with the heat-exchange medium channel of the heating end 12 via the second connection pipe 14, and the liquid channel of the condensation end 11 is directly communicated with the heat-exchange medium channel of the heating end 12. In this way, it is unnecessary to provide the first connection pipe 13, and the connection pipe assembly includes the second connection pipe 14. In this case, the first bursting component 20 is provided at the condensation end 11; or the first bursting component 20 is provided at the heating end 12; or the first bursting component 20 is provided on the second connection pipe 14; alternatively, each of at least two of the condensation end 11, the heating end 12 and the second connection pipe 14 is provided with the first bursting components 20. The bursting pressure of the first part of the first bursting component 20 is lower than the bursting pressure of the second part of the first bursting component 20. Alternatively, the bursting pressure of the first bursting component 20 is lower than that of the component (the condensation end 11, the heating end 12 or the second connection pipe 14) where the first bursting component 20 is located.

Based on the structure of the heat sink 10, two specific structures of the heat dissipation apparatus 100 will be described below with reference to FIG. 1 and FIG. 2.

In a first structure, as shown in FIG. 1, the heat dissipation apparatus 100 includes a heat sink 10 and a first bursting component 20. The heat sink 10 includes a condensation end 11, a heating end 12, a first connection pipe 13 and a second connection pipe 14, wherein the first connection pipe 13 is in communication with an outlet of the condensation end 11 and an inlet of the heating end 12, and the second connection pipe 14 is in communication with an inlet of the condensation end 11 and an outlet of the heating end 12. The condensation end 11 includes a first collecting pipe 112a, a condensation pipe 111 and a second collecting pipe 112b, wherein the first connection pipe 13 is in communication with the first collecting pipe 112a, and the second connection pipe 14 is in communication with the second collecting pipe 112b. There are two first bursting components 20, namely one first bursting component 20 is provided on the first collecting pipe 112a, and the other first collecting pipe 112a is provided at the heating end 12.

In the above structure, the first collecting pipe 112a is used to collect the heat-exchange medium in each condensation pipe 111 to realize the convergence of the heat exchange media in all the condensation pipes 111, so that the pressure of the heat-exchange medium in the first collecting pipe 112a is higher than the pressure of the heat-exchange medium at the condensation end 11 in other positions, the pressure of the heat-exchange medium in the first bursting component 20 communicated with the first collecting pipe 112a is relatively high, so the first bursting component 20 can break out in time, thereby improving the safety and reliability.

In the above structure, the pressure of the heat-exchange medium in the heating end 12 is prone to exceed a set value, so that the first bursting component 20 communicated with the heating end 12 is prone to break out in time, thereby improving the safety and reliability.

The two first bursting components 20 may be located on the same side of the heating end 12, or on different sides of the heating end 12. The relative positions of the two first bursting components 20 can be determined according to actual situations, which is not limited in the embodiment of the present application.

In the heat dissipation apparatus 100 shown in FIG. 1, it is also possible to increase the number of the first bursting components 20, and add another first bursting component 20 at other positions, which is not limited in the embodiment of the present application.

In a second structure, as shown in FIG. 2, the heat dissipation apparatus 100 includes a heat sink 10 and a first bursting component 20. The heat sink 10 includes a condensation end 11, a heating end 12 and a first connection pipe 13, and one heating end 12 and two condensation ends 11 are provided. One of the condensation ends 11 is inclined relative to the heating end 12, and this condensation end 11 is directly communicated with the heating end 12. An outlet of the other condensation end 11 is communicated with an inlet of the heating end 12 via the first connection pipe 13, and an inlet of this condensation end 11 is directly communicated with an outlet of the heating end 12. The first bursting component 20 is provided at the heating end 12.

In the above structure, the pressure of the heat-exchange medium in the heating end 12 is prone to exceed a set value, so that the first bursting component 20 communicated with the heating end 12 is prone to blast in time, thereby improving the safety and reliability.

The first bursting component 20 may be located on the same side of the two condensation ends 11, or between the two condensation ends 11.

The first bursting component 20 and the condensation end 11 may be located on the same side of the heating end 12, or on different sides of the heating end 12.

At least one first bursting component 20 may be provided, which is not limited in the embodiment of the present application.

In the heat dissipation apparatus 100 shown in FIG. 2, the first bursting component 20 may also be added at other positions. Alternatively, the number of the condensation ends 11 may be increased or reduced, which is not limited in the embodiment of the present application.

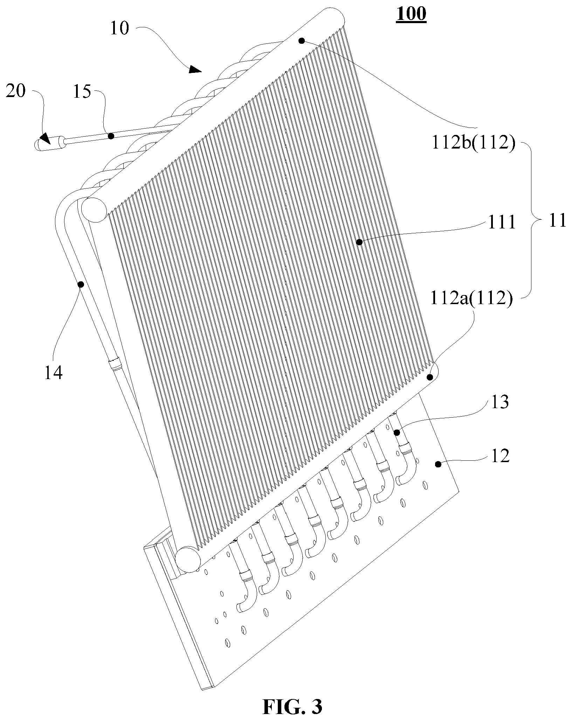

As shown in FIG. 3 to FIG. 5, in order to facilitate the injection of a heat-exchange medium into the heat-exchange medium channel, the heat sink 10 has an injection pipe 15, which is used to inject the heat-exchange medium. It should be noted that the channel in the injection pipe 15 is a portion of the heat-exchange medium channel. In this case, the first bursting component 20 is provided on the injection pipe 15 or on other components of the heat sink 10. Alternatively, the injection pipe 15 is provided with at least one first bursting component 20, and other component of the heat sink 10 is provided with at least one first bursting component 20.

Because the injection pipe 15 has a certain length, the first bursting component 20 is provided on the injection pipe 15, so that the first bursting component 20 can be further away from other parts of the heat sink 10, and the damage caused by bursting can be further reduced.

The inject pipe 15 is a round pipe, square pipe, rectangular pipe, or a pipe of other shape.

When the first bursting component 20 is provided on the injection pipe 15, the bursting pressure of the first part of the first bursting component 20 is lower than the bursting pressure of that of the first bursting component 20; alternatively, the bursting pressure of the first bursting component 20 is lower than that of the injection pipe 15. For the descriptions of the first part and the second part of the first bursting component 20, reference can be made to the foregoing.

As described above, the first bursting component 20 may be a pipe, so that the bursting pressure of the first bursting component 20 is lower than that of the injection pipe 15. Reference can be made to the specific manner in which the bursting pressure of the first part is lower than that of the second part, so as to realize that the bursting pressure of the first bursting component 20 is lower than that of the injection pipe 15, and details will not be described herein again.

As shown in FIG. 3 and FIG. 4, the first bursting component 20 is provided at one end of the injection pipe 15 in an axial direction of the injection pipe 15. As shown in FIG. 5, the first bursting component 20 is provided on a circumferential side wall of the injection pipe 15.

As described above, the heat sink 10 includes a condensation end 11 and a heating end 12, and the injection pipe 15 may be provided at the heating end 12 or the condensation end 11. Alternatively, there are at least two injection pipes 15, the heating end 12 is provided with at least one of the injection pipes 15, and the condensation end 11 is provided with at least one of the injection pipes 15.

As described above, the heat sink 10 includes a condensation end 11, a heating end 12 and a connection pipe assembly. The connection pipe assembly includes at least one of a first connection pipe 13 and a second connection pipe 14, and the injection pipe 15 is provided on at least one of the condensation end 11, the heating end 12 and the connection pipe assembly. Illustratively, the injection pipe 15 may be provided at the condensation end 11, the heating end 12, the first connection pipe 13 or the second connection pipe 14.

As described above, the heat sink 10 includes a condensation end 11, the condensation end 11 includes a condensation pipe 111 and a collecting pipe 112, and the injection pipe 15 may be provided on at least one of the condensation pipe 111 and the collecting pipe 112. Since the collecting pipe 112 includes one of the first collecting pipe 112a and the second collecting pipe 112b, the injection pipe 15 may be provided on the first collecting pipe 112a or the second collecting pipe 112b. For example, as shown in FIG. 3 to FIG. 5, the injection pipe 15 is provided on the second collecting pipe 112b, which is above the first collecting pipe 112a, so it is convenient to inject the heat-exchange medium.

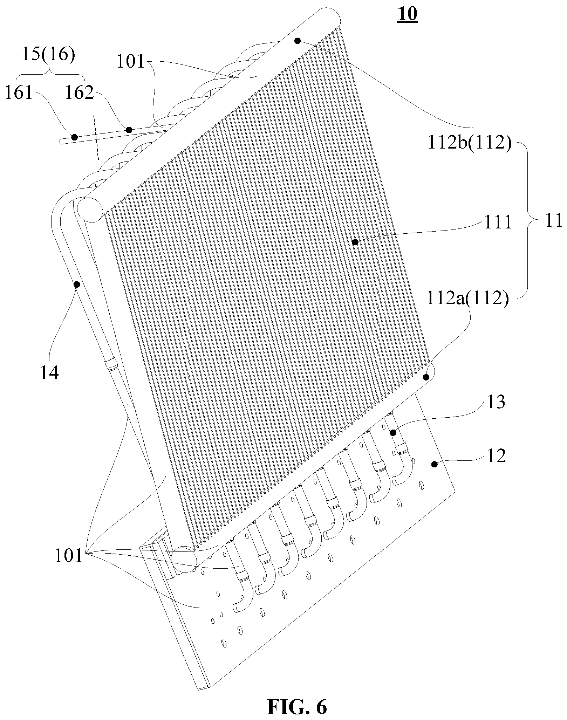

In the embodiment of the present application, the heat sink 10 may have above structure, or may have other structure. As shown in FIG. 6, in some embodiments, the components forming the heat-exchange medium channel in the heat sink 10 are channel components 101, and some of all the channel components 101 are second bursting components 16. It can be understood that the number of the second bursting components 16 is smaller than the number of all the channel components 101.

It should be noted that the second bursting component 16 breaks out prior to other channel components 101; or the second bursting component 16 breaks out and other channel components 101 does not breaks out. The bursting pressure of the second bursting component 16 may be higher than, lower than or equal to that of the first bursting component 20. The bursting pressure of the second bursting component 16 refers to a maximum pressure borne by the second bursting component 16 when it breaks out.

According to the foregoing description of the heat sink 10, the condensation end 11, the heating end 12, the first connection pipe 13, the second connection pipe 14 and the injection pipe 15 can all be understood as the channel components 101, and the condensation pipe 111 and the collecting pipe 112 at the condensation end 11 can both be understood as the channel components 101.

In the above heat sink 10, when the temperature of the heat-exchange medium rises to a set value (the pressure of the heat-exchange medium rises to the bursting pressure of the second bursting component 16), the second bursting component 16 breaks out. A spot bursting can be realized by setting the location of the second bursting component 16, and an orientated bursting can be realized by setting the orientation of the second bursting component 16, so that foreign matters or shock waves generated by bursting can be far away from a specific device or a specific area, the damage to the specific device or personnel at the specific area can be reduced, and the damage caused by bursting can be reduced.

Moreover, by setting the bursting pressure of the second bursting component 16, the second bursting component 16 can break out at a set pressure, thereby improving the safety and reliability of the heat sink 10.

Based on the above technical effects, the heat sink 10 may be applied separately without the first bursting component 20.

In order to achieve that the second bursting component 16 breaks out prior to other channel components 101, or that the second bursting component 16 breaks out and other channel components 101 does not break out, the bursting pressure of the second bursting component 16 may be lower than that of the channel component 101 where the second bursting component 16 is located. In this way, by setting the location of the second bursting component 16, the bursting at a specific position and in a specific direction can be realized.

In order to achieve that the second bursting component 16 breaks out prior to other channel components 101, or that the second bursting component 16 breaks out and other channel components 101 does not break out, the bursting pressure of a third part 161 of the second bursting component 16 can be lower than that of a fourth part 162 of the second bursting component 16, and each of the third part 161 and the fourth part 162 is used to form a heat-exchange medium channel. In this way, by setting the location of the second bursting component 16 and the position of the third part 161, the bursting position and direction can be set, thereby further reducing the damage caused by the bursting.

It should be noted that the distribution of the third part 161 and the fourth part 162 of the second bursting component 16 may refer to the distribution of the first part 21 and the second part 22 of the first bursting component 20, and will not be repeated here.

As described above, the heat sink 10 includes a condensation end 11 and a heating end 12, the condensation end 11 is defined as a second bursting component 16; alternatively, the heating end 12 is defined as a second bursting component 16; alternatively, both of the condensation end 11 and the heating end 12 are defined as a second bursting component 16.

As described above, the heat sink 10 includes a condensation end 11, a heating end 12 and a connection pipe assembly, wherein the connection pipe assembly includes at least one of a first connection pipe 13 and a second connection pipe 14, and at least one of the condensation end 11, the heating end 12 and the connection pipe assembly is defined as a second bursting component 16. Illustratively, at least one of the condensation end 11, the heating end 12, the first connection pipe 13 and the second connection pipe 14 is defined as a second bursting component 16.

As mentioned above, the heat sink 10 includes a condensation end 11, and the condensation end 11 includes at least one condensation pipe 111. In a case that the condensation end 11 is defined as a second bursting component 16, the at least one condensation pipe 111 may be the second bursting component 16. In this way, the condensation pipe 111 may be designed as the condensation pipe 111, which simplifies the modification to the heat sink 10 and reduces the impact on the cost of the heat sink 10.

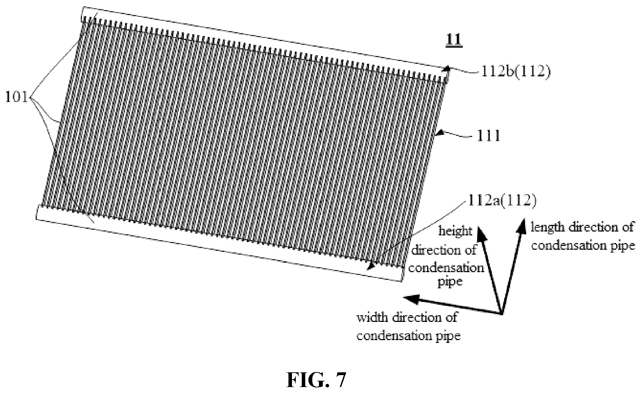

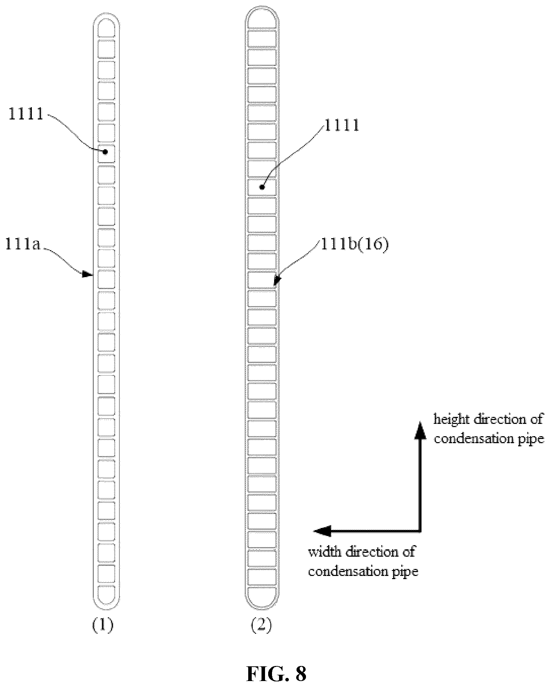

As described above, more than two condensation pipes 111 are provided at the condensation end 11. In this case, as shown in FIG. 7 and FIG. 8, at least one of the condensation pipes 111 may be a first condensation pipe 111a, and at least one of the condensation pipes 111 may be a second condensation pipe 111b, and the second condensation pipe 111b may be the second bursting component 16. In order to achieve that the second bursting component 16 breaks out prior to other channel components 101, or that the second bursting component 16 breaks out and other channel components 101 does not break out, the bursting pressure of the second condensation pipe 111b can be set to be lower than that of the first condensation pipe 111a.

In order to facilitate setting the bursting pressure of the second condensation pipe 111b to be lower than that of the first condensation pipe 111a, on the one hand, the second condensation pipe 111b can have a length greater than that of the first condensation pipe 111a in a set direction, and the set direction is perpendicular to a flow guide direction of the condensation pipe 111.

On the other hand, the second condensation pipe 111b may have a channel flow area greater than that of the first condensation pipe 111a.

On the other hand, a wall thickness of the second condensation pipe 111b may be smaller than that of the first condensation pipe 111a.

On the other hand, a material strength of the second condensation pipe 111b may be smaller than that of the first condensation pipe 111a.

The above four aspects may be implemented separately or in any combination, which will not be limited in the embodiment of the present application.

The type of the condensation pipe 111 can be determined according to an actual situation. As shown in FIG. 8, the condensation pipe 111 may be a microchannel flat pipe in order to improve the heat-exchange efficiency. It can be understood that each of the first condensation pipe 111a and the second condensation pipe 111b is a microchannel flat pipe, and the length direction of the condensation pipe 111 is the flow guide direction of the condensation pipe 111.

In the case that the condensation pipe 111 is a microchannel flat pipe, in order to realize that the length of the second condensation pipe 111b is greater than that of the first condensation pipe 111a in the set direction, the second condensation pipe 111b may have a height greater than that of the first condensation pipe 111a, and the height of the condensation pipe 111 is perpendicular to the length direction of the condensation pipe 111; and/or the second condensation end pipe 111b has a width greater than that of the first condensation pipe 111a, and the width of the condensation pipe 111 is perpendicular to the length direction of the condensation pipe 111.

In the case that the condensation pipe 111 is a microchannel flat pipe, in order to realize that the channel flow area of the second condensation pipe 111b is larger than that of the first condensation pipe 111a, as shown in FIG. 8, each of flat-pipe holes 1111 of the second condensation pipe 111b may have a cross-sectional area greater than that of each of flat-pipe holes 1111 of the first condensation pipe 111a, and the number of the flat-pipe holes 1111 of the second condensation pipe 111b is equal to that of the flat-pipe holes 1111 of the first condensation pipe 111a. Alternatively, the cross-sectional area of the flat-pipe hole 1111 of the second condensation pipe 111b may be equal to that of the flat-pipe hole 1111 of the first condensation pipe 111a, and the number of the flat-pipe holes 1111 of the second condensation pipe 111b is greater than that of the flat-pipe holes 1111 of the first condensation pipe 111a. Alternatively, the cross-sectional area of the flat-pipe hole 1111 of the second condensation pipe 111b may be greater than that of the flat-pipe hole 1111 of the first condensation pipe 111a, and the number of the flat-pipe holes 1111 of the second condensation pipe 111b is greater than that of the flat-pipe holes 1111 of the first condensation pipe 111a. Alternatively, the cross-sectional area of the flat-pipe hole 1111 of the second condensation pipe 111b may be greater than that of the flat-pipe hole 1111 of the first condensation pipe 111a, and the number of the flat-pipe holes 1111 of the second condensation pipe 111b is smaller than that of the flat-pipe holes 1111 of the first condensation pipe 111a. Alternatively, the cross-sectional area of the flat-pipe hole 1111 of the second condensation pipe 111b may be smaller than that of the flat-pipe hole 1111 of the first condensation pipe 111a, and the number of the flat-pipe holes 1111 of the second condensation pipe 111b is greater than that of the flat-pipe holes 1111 of the first condensation pipe 111a.

In an actual situation, when the second condensation pipe 111b has the same material as the first condensation pipe 111a, a material hardness of the second condensation pipe 111b may be smaller than that of the first condensation pipe 111a, so that the bursting pressure of the second condensation pipe 111b is lower than that of the first condensation pipe 111a. Illustratively, each of the second condensation pipe 111b and the first condensation pipe 111a is a metal pipe, and a material hardness of the second condensation pipe 111b may be smaller than that of the first condensation pipe 111a.

As described above, the heat sink 10 includes a condensation end 11, and the condensation end 11 includes a condensation pipe 111 and a collecting pipe 112. The collecting pipe 112 includes one of a first collecting pipe 112a and a second collecting pipe 112b, so at least one of the condensation pipe 111, the first collecting pipe 112a and the second collecting pipe 112b is defined as a second bursting component 16.

As described above, the heat sink 10 includes an injection pipe 15, as shown in FIG. 6, the injection pipe 15 may be the second bursting component 16. Since the injection pipe 15 has a certain length, the injection pipe 15 is the second bursting component 16, so that the second bursting component 16 may be far away from other components of the heat sink 10 as much as possible, and the damage caused by bursting may be further reduced.

The bursting pressure of the injection pipe 15 is lower than that of the component where the injection pipe 15 is located, or the bursting pressure of the third part 161 of the injection pipe 15 is lower than that of the fourth part 162 of the injection pipe 15. The distribution of the third part 161 and the fourth part 162 of the injection pipe 15 can refer to the distribution of the first part 21 and the second part 22 of the first bursting component 20. When the second bursting component 16 is the injection pipe 15, the structure and type of the second bursting component 16 may refer to those of the first bursting component 20, which will not be described here.

A specific position of the injection pipe 15 may refer to the foregoing description, and details will not be described here again.

In actual situations, at least one second bursting component 16 may be provided. When more than two second bursting components 16 are provided, at least two of the second bursting components 16 are the same channel component 101, for example, at least two of the second bursting components 16 are condensation pipes 111. Alternatively, at least two of the second bursting components 16 are different channel components 101, for example, one of the second bursting components 16 is the injection pipe 15, and at least one of the second bursting components 16 is a condensation pipe 111.

Based on the heat dissipation apparatus 100 and the heat sink 10 having the second bursting component 16 according to the above embodiments, an electrical device is further provided according to an embodiment of the present application. The electrical device includes the heat dissipation apparatus 100 or the heat sink 10 having the second bursting component 16 according to above embodiments.

The electrical device further includes a heating apparatus, and the heat sink 10 is configured to dissipate heat of the heating apparatus. For example, the heating apparatus may be a power device, a capacitor, or other devices.

The electrical device may be an inverter or other device having a heating apparatus, and the type of the electrical device is not limited in the embodiment of the present application.

The technical features mentioned above and the technical features separately shown in the accompanying drawings may be arbitrarily combined with each other as long as the combined technical features are not contradictory to each other. All feasible combinations of features are technical contents expressly recorded herein. Any of multiple technical features included in the same statement may be applied independently without necessarily being applied with other technical features.

The above description of the disclosed embodiments enables those skilled in the art to implement or utilize the present application. Various modifications to these embodiments will be apparent to those skilled in the art, and the general principles defined herein can be implemented in other embodiments without departing from the spirit or scope of the present application. Therefore, the present application will not be limited to the embodiments shown herein, but should conform to the widest scope consistent with the principle and novel features disclosed herein.

## Claims

1. A heat dissipation apparatus (100), **characterized by** comprising a heat sink (10) and a first bursting component (20); wherein the heat sink (10) has a heat-exchange medium channel, and the first bursting component (20) is provided on the heat sink (10), and the first bursting component (20) is in communication with the heat-exchange medium channel.

2. The heat dissipation apparatus (100) according to claim 1, wherein a bursting pressure of a first part (21) of the first bursting component (20) is lower than a bursting pressure of a second part (22) of the first bursting component (20).

3. The heat dissipation apparatus (100) according to claim 2, wherein the first bursting component (20) is a pipe, and the first part (21) and the second part (22) are distributed in an axial direction of the first bursting component (20).

4. The heat dissipation apparatus (100) according to claim 3, wherein two second parts(22) are distributed in the axial direction of the first bursting component (20), and the first part (21) is located between the two second parts (22).

5. The heat dissipation apparatus (100) according to claim 4, wherein a cross section of the first part (21) is the same as a cross section of the second part (22) in shape, and the cross sections are perpendicular to the axial direction of the first bursting component (20);
wherein an inner wall of the first part (21) has a width equal to that of an inner wall of the second part (22) in a radial direction of the first bursting component (20), and an outer wall of the first part (21) has a width smaller than that of an outer wall of the second part (22) in the radial direction; or
an inner wall of the first part (21) has a width greater than that of an inner wall of the second part (22) in the radial direction, and an outer wall of the first part (21) has a width equal to that of an outer wall of the second part (22) in the radial direction.

6. The heat dissipation apparatus (100) according to claim 2, wherein
a wall thickness of the first part (21) of the first bursting component (20) is smaller than a wall thickness of second part (22) of the first bursting component (20);
and/or, the first bursting component (20) is a pipe, the first part (21) and the second part (22) are distributed in an axial direction of the first bursting component (20), a cross section of the first part (21) is the same as a cross section of the second part (22) in shape, and the cross sections are perpendicular to the axial direction of the first bursting component (20); an inner wall of the first part (21) has a width greater than a width of an inner wall of the second part (22) in an radial direction of the first bursting component (20);
and/or, the first bursting component (20) is a pipe, the first part (21) and the second part (22) are distributed in an axial direction of the first bursting component (20), a cross section of the first part (21) is the same as a cross section of the second part (22) in shape, and the cross section is perpendicular to the axial direction of the first bursting component (20); an outer wall of the first part (21) has a width smaller than a width of an outer wall of the second part (22) in an radial direction of the first bursting component (20);
and/or, a material strength of the first part (21) is smaller than a material strength of the second part (22);
and/or, the first part (21) has a groove.

7. The heat dissipation apparatus (100) according to claim 2, wherein the first bursting component (20) is a single-layer pipe.

8. The heat dissipation apparatus (100) according to claim 2, wherein the first part (21) is a single-layer pipe and the second part (22) is a multi-layer pipe; or
each of the first part (21) and the second part (22) is a multiple-layer pipe, and a number of layers of the first part (21) is smaller than a number of layers of the second part (22).

9. The heat dissipation apparatus (100) according to claim 1, wherein a bursting pressure of the first bursting component (20) is lower than a bursting pressure of the heat sink (10).

10. The heat dissipation apparatus (100) according to claim 1, wherein one end of the first bursting component (20) is fixed to the heat sink (10) and is in communication with the heat-exchange medium channel; and/or
the first bursting component (20) is a pipe.

11. The heat dissipation apparatus (100) according to claim 1, wherein the heat sink (10) comprises a condensation end (11), a heating end (12) and a connection pipe assembly;
wherein the connection pipe assembly comprises at least one of a first connection pipe (13) or a second connection pipe (14), the first connection pipe (13) is in communication with an outlet of the condensation end (11) and an inlet of the heating end (12), and the second connection pipe (14) is in communication with an inlet of the condensation end (11) and an outlet of the heating end (12); and the first bursting component (20) is provided on at least one of the condensation end (11), the heating end (12) and the connection pipe assembly.

12. The heat dissipation apparatus (100) according to claim 1, wherein the heat sink (10) comprises a condensation end (11) and a heating end (12); the condensation end (11) is connected to the heating end (12), and a heat-exchange medium channel of the condensation end (11) is directly communicated with a heat-exchange medium channel of the heating end (12);
wherein the first bursting component (20) is provided on at least one of the condensation end (11) and the heating end (12).

13. The heat dissipation apparatus (100) according to claim 11 or 12, wherein the first bursting component (20) is provided at the condensation end (11), and the first bursting component (20) is provided on at least one of a collecting pipe and a condensation pipe of the condensation end (11).

14. The heat dissipation apparatus (100) according to claim 11 or 12, wherein the heating end (12) is an evaporation end.

15. The heat dissipation apparatus (100) according to any one of claims 1 to 12, wherein the heat sink (10) is provided with an injection pipe (15) for injecting a heat-exchange medium, and the first bursting component (20) is provided on the injection pipe (15).

16. The heat dissipation apparatus (100) according to claim 15, wherein the first bursting component (20) is provided at one end of the injection pipe (15) in an axial direction; alternatively, the first bursting component (20) is provided on a circumferential side wall of the injection pipe (15).

17. The heat dissipation apparatus (100) according to claim 15, wherein
the injection pipe (15) is provided on at least one of the condensation end (11) and the heating end (12) of the heat sink (10); or the injection pipe (15) is provided on at least one of the condensation end (11), the heating end (12) and the connection pipe assembly of the heat sink (10).

18. The heat dissipation apparatus (100) according to any one of claims 1 to 12, wherein components of the heat sink (10) forming the heat-exchange medium channel are channel components (101), and some of the channel components (101) are defined as a second bursting component (16).

19. The heat dissipation apparatus (100) according to claim 18, wherein a bursting pressure of the second bursting component (16) is lower than a bursting pressure of the channel component (101) where the second bursting component (16) is located; alternatively, a bursting pressure of a third part (161) of the second bursting component (16) is lower than a bursting pressure of a fourth part (162) of the second bursting component (16).

20. The heat dissipation apparatus according to claim 18, wherein the heat sink (10) is provided with an injection pipe (15) for injecting a heat-exchange medium, and the injection pipe (15) is the second bursting component (16); and/or
at least one of the condensation end (11), the heating end and the connection pipe assembly of the heat sink (10) is the second bursting component (16).

21. A heat sink (10), **characterized by** comprising a condensation end (11) and a heating end,
wherein the heating end is in communication with the condensation end (11), and the heating end and the condensation end (11) form a circulation loop;
wherein the condensation end (11) comprises at least one condensation pipe, and at least one of the condensation pipes is defined as a second bursting component (16); and/or the heat sink (10) further comprises an injection pipe (15) for injecting a heat-exchange medium, and the injection pipe (15) is defined as a second bursting component (16).

22. The heat sink (10) according to claim 21, wherein a bursting pressure of the second bursting component (16) is lower than a bursting pressure of the channel component where the second bursting component (16) is located.

23. The heat sink (10) according to claim 21, wherein a bursting pressure of a third part (161) of the second bursting component (16) is lower than a bursting pressure of a fourth part (162) of the second bursting component (16).

24. The heat sink (10) according to claim 21, wherein at least two condensation pipes are provided, at least one of the condensation pipes is defined as a first condensation pipe (111a), and at least one of the condensation pipes is defined as a second condensation pipe (111b); the second condensation pipe (111b) is defined as a second bursting component (16), and a bursting pressure of the second condensation pipe (111b) is lower than a bursting pressure of the first condensation pipe (111a).

25. The heat sink (10) according to any one of claims 21 to 24, wherein
the injection pipe (15) is provided on at least one of the heating end (12) and the condensation end (11); or
the heat sink (10) further comprises a connection pipe assembly, and the connection pipe assembly comprises at least one of a first connection pipe (13) and a second connection pipe (14); wherein the first connection pipe (13) is in communication with an outlet of the condensation end (11) and an inlet of the heating end (12), the second connection pipe (14) is in communication with an inlet of the condensation end (11) and an outlet of the heating end (12), and the injection pipe (15) is provided on at least one of the condensation end (11), the heating end (12) and the connection pipe assembly.

26. The heat sink (10) according to any one of claims 21 to 24, wherein the heating end (12) is an evaporation end.

27. An electrical device, **characterized by** comprising: the heat dissipation apparatus (100) according to any one of claims 1 to 20, or the heat sink (10) according to any one of claims 21 to 26.
